# EUROPEAN PATENT APPLICATION

(11) **EP 2 620 780 A1**
(43) Date of publication of application: **31.07.2013**
(21) Application number: 12152676.8
(22) Date of filing: 26.01.2012
(51) Int. Cl.: G01R 31/34, G01R 31/42

(54) **Grid performance test unit for wind turbines**

(71) Applicant: Siemens Aktiengesellschaft, 80333 München (DE)
(72) Inventor: Goldenbaum, Nikolaus Moeller, 8600 Silkeborg (DK); Lund, Mogens, 6920 Videbaek (DK)

(57) **Abstract**

A test unit (2) for testing an electric power generator (1) is provided. The test unit (2) has first terminals (10) connectable to a utility grid (3) and second terminals (11) connectable to the electric power generator (1) and further comprises a first converter (12) connected between the first terminals (10) and a DC link (14) and a second converter (13) connected between the DC link (14) and the second terminals (11). The first converter (12) is adapted to convert electricity between an alternating grid voltage present at the first terminals (10) and a DC voltage present at the DC link (14). The second converter (13) is adapted to convert electricity between the DC voltage present at the DC link (14) and an alternating generator voltage present at the second terminals (11).

## Description

The invention deals with a test unit for testing electric power generators such as wind turbines or photovoltaic power plants.

The performance and reliability of the electric power system strongly depends on the behaviour of the generators such as wind turbines both in normal and faulted system states. Grid operators are required to guarantee reliable delivery of power with a quality that meets certain standards to ensure the untroubled operation of the user and power system equipment. Thus, extensive measures have to be taken to ensure that the power generators connected to the utility grid perform according to well-defined standards and are well documented and tested.

The massive growth in the number of small generator plants such as wind turbines or photovoltaic power plants in the public power system entails increasing attention to the behaviour of these components. Hence, the availability of high quality documentation and test verification of such generator devices is of increasing importance.

Preferably test scenarios should include fault tests which test the generators' reaction to unexpected transient variations in the voltage (under-voltage, over-voltage, voltage variations) or frequency (under-frequency, over-frequency, frequency change). Furthermore, the capability of the generator should be tested, e.g. the capability to provide reactive power, the performance at an exact operating point, P, Q and U controller performance, power quality and robustness of converter control. In addition function tests testing relay settings and frequency response of the generator should be performed.

Some of these tests can be performed using large devices comprising coils and switches which can be configured to test voltage dip characteristics. Information on such equipment can be found in the 61400-21 standard.

Over-voltage has not been tested to date. Frequency-related tests have been conducted by injecting control signals into the generator control in order to simulate frequency events. Reactive capabilities have been measured by forcing the generator into full export/import of reactive power followed by stepping the active power generation between 0 and 100% rated power. However, this method has significant shortcomings as it is not possible to measure the reactive capabilities over the entire normal operating voltage range under normal conditions. The quality of the provided power has been determined to present measuring different aspects such as harmonic emission and flicker. Unfortunately such measurements are site-specific and thus not necessarily representative of the performance of the same generator or generator type at locations with different grid characteristics. Robustness of the generator control is only tested using mathematic approaches and simulations which in some cases may be verified by referring lab measurements.

In view of the unsatisfactory state of the art a device is sought which offers reliable and reproducible tests for electric power generators.

The invention therefore provides a test unit for testing an electric power generator. The test unit has first terminals connectable to a utility grid and second terminals connectable to an electric power generator and further comprises a first converter connected between the first terminals and a DC link and a second converter connected between the DC link and the second terminals. The first converter is adapted to convert electricity between an alternating grid voltage present at the first terminals and a DC voltage present at the DC link. The second converter is adapted to convert electricity between the DC voltage present at the DC link and an alternating generator voltage present at the second terminals.

The test unit of the invention makes it possible to test the electric power generator, usually a wind turbine, a photovoltaic power plant or the like, by simulating a utility grid to which the generator connects on a full scale. From the point of view of the generator the test unit behaves exactly like a utility grid to which the generator connects, however, this behaviour can be controlled as required for any desired test. The second converter interfacing the generator emulates the desired behaviour of the utility grid while receiving any power generated by the electric power generator during the test and provides the power to the DC link. The first converter connected to the DC link will feed this power to the utility grid in a grid compliant way. In this way it is possible to dispose of the power generated during the tests without violating any constraints set by the grid operator while exposing any desired simulated grid behaviour to the electric power generator connected to the test unit.

Preferably the second converter is adapted to convert electricity in accordance with a control signal variably setting at least one of a frequency, a phase and a voltage level of the alternating generator voltage. A person conducting tests can provide appropriate control signals to the test unit to control the frequency, phase or voltage behaviour exposed by the test unit.

In preferred embodiments of the inventive test unit the second converter may be adapted to convert electricity in accordance with the control signal individually for each phase in a three-phase alternating generator voltage. This makes it possible to test the generator's response to asymmetries between the phases of a three-phase utility grid, e.g. one lagging phase signal.

The test unit may further comprise first coupling means connected between the first terminals and the first converter and second coupling means connected between the second terminals and the second converter. The coupling means are useful if the alternating generator voltage and the alternating grid voltage are too high for the converters of the test unit. In such a case the voltage at the terminals of the converters can be reduced by the coupling means.

The first coupling means may be adapted to conduct current between the alternating grid voltage and a first converter voltage which corresponds to the alternating grid voltage divided by a first voltage ratio and the second coupling means may be adapted to conduct current between the alternating generator voltage and a second converter voltage which corresponds to the alternating generator voltage divided by a second voltage ratio. The first and second voltage ratios can be the same or can be different from each other.

At least one of the first and the second coupling means may include a transformer. The transformer can be a multi-tap transformer which allow a selectable transformer ratio.

Alternatively at least one of the first and the second coupling means may include a line reactor. Line reactors attenuate any spikes and high-frequency components that may be present in the power signals due to the switching operation of the converters.

The test unit may further include a current detector connected between the second terminals and the second converter and adapted to measure a current flowing between the electric power generator and the second converter. The signal from the current detector can be used in order to simulate certain impedance characteristics at the terminals of the equipment under test (i.e. the electric power generator). This can be done by setting the voltage reference for the generator and the amount of current converted by the second converter accordingly. For this reason a preferred embodiment of the invention may further comprise a controller adapted to determine reference set-points for the electric power generator, to transmit the determined reference set-points to the electric power generator and to set an impedance at the second terminals.

The test unit may comprise a first voltage sensor adapted to measure the DC voltage of the DC link. The first converter may be adapted to transport electricity from the DC link to the first terminals in accordance with the measured DC voltage. The first voltage sensor can be used to keep the DC voltage of the DC link within reasonable bounds. E.g., the amount of power fed from the DC link to the utility grid by the first converter may depend on the actual DC voltage of the DC link.

The test unit may also comprise a second voltage sensor adapted to measure the alternating grid voltage. The first converter may be adapted to transport electricity from the DC link to the first terminals in accordance with the measured alternating grid voltage. In this way the test unit can be used to actively control the alternating grid voltage which may be an advantage in situations where specific grid requirements are to be met.

Preferably the test unit has a weight and size so as to be transportable. The transportable test unit of the invention is a very useful tool because it provides the possibility of testing the behaviour of an electric power generator under real-world conditions at the site of the electric power generator. For example, in the case of a wind turbine it is possible to test the turbine's response to any kind of grid behaviour. In more detail, the transportable test unit can be used to observe vibrations of the tower of the wind turbine, variations in rotor speed etc. In a low voltage rid through (LVRT) the voltage of one or more phases of utility grid drops for a certain period of time. In such cases the electric power generator produces less or no counter torque which causes the wind rotor of the wind turbine to accelerate. The wind turbine needs to react to this situation in order to protect integrity of the installation. Typically the rotor blades would be pitched out of the wind which also reduces the forces applied to the wind turbine tower by the wind. With the forces removed, the wind turbine tower will react similar to a released leaf spring and strong vibrations may appear. The wind turbine will have to pass such a situation without triggering any over-speed, vibration or drive train oscillation alarms. However, such tests are not possible on a test bench where environmental influences cannot be simulated.

While a modular approach where the test unit will be demounted into two or more parts that can be reassembled easily at the test site is viable, advantageous embodiments of the test unit can be transported without the need of deconstruc-tion.

In preferred embodiments of the transportable test unit the weight and size of the test unit are chosen such that the test unit can be transported by a motor truck. This makes relocation of the test unit easy because the wind turbines itself will typically be transported to the site of the wind park by means of motor trucks. Accordingly, the site of the wind park will usually be accessible by motor trucks.

Preferably the weight and size of the test unit are such that the test unit can be transported in an ISO-container or a standard trailer. Such containers (20" or 40" containers) are standardised and used worldwide. Again, the test unit may be stowed in the container or trailer in either a demounted or mounted state.

These and other features, aspects and advantages of the invention will become better understood with reference to the following description and drawings.

The invention will now be described in more detail, by way of example only, with reference to the accompanying drawings in which:
Fig. 1 shows a test setup including the test unit of the invention;
Fig. 2 shows a first exemplary embodiment of the invention;
Fig. 3 shows a second exemplary embodiment of the invention; and
Fig. 4 shows a third exemplary embodiment of the invention.

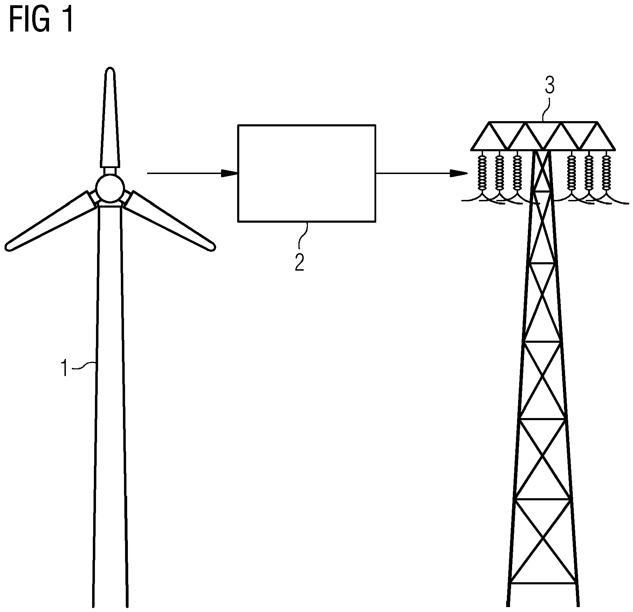

Fig. 1 shows a test setup including the test unit of the invention. The test unit 2 is connected between an electric power generator such as a wind turbine 1 and a utility grid 3 effectively decoupling the two. The test unit 2 can transport electric power from the wind turbine 1 to the utility grid 3 if a test is run where the electric power generator operates in generator mode. In addition the test unit 2 can act as a utility grid showing a behaviour as required for a specific test while keeping the real utility grid untroubled. In this way the test unit can be used to run any type of test on the electric power generator such as under-voltage, over-voltage, under-frequency, over-frequency, frequency-change and many more.

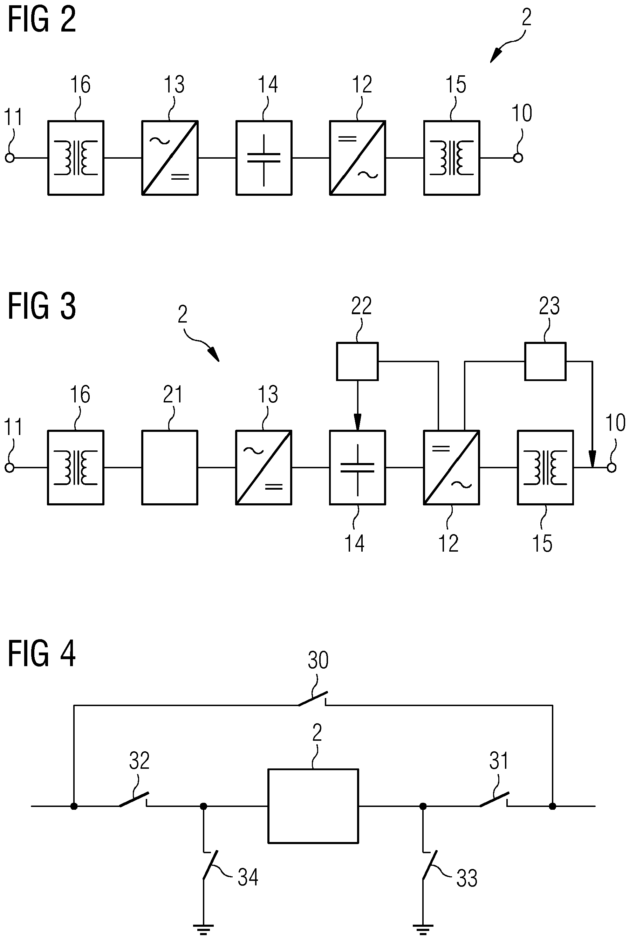

Fig. 2 shows a first exemplary embodiment of the invention. The test unit 2 of Fig. 2 comprises first terminals 10 for connecting to the utility grid and second terminals 11 for connecting to the electric power generator. The core of the test unit comprises first and second converters 12 and 13 which are connected back-to-back via a DC link 14. The converters are adapted to convert electricity between a DC voltage of the DC link and an alternating voltage at their other end. In some embodiments the converters may be directly connected to the first or second terminals. This may be an option for electric power generators and utility grid that whose voltage within the capability range of the converter hardware. However, in most cases coupling means may be employed to connect the converters 12 and 13 to their respective terminals 10 or 11. In the embodiment of Fig. 2 transformers 15 and 16 are provided in order to transform the voltages at the first and second terminals to a level that is adequate for the first and second converters. The transformers 15 and 16 may be multi-tap transformers which have a selectable transformer ratio.

Fig. 3 shows a second exemplary embodiment of the invention. In the drawings the same reference numerals refer to the same or similar components. Repetitive description of components present in both Figs. 2 and 3 will be omitted for the sake of conciseness.

As in the first embodiment, the first and second transformers 15 and 16 are optional. The second embodiments differs from that of Fig. 2 in that a current detector 21 is connected between the second converter 13 and the second terminals 11. In the example of Fig. 3 the current detector 21 is connected between the second coupling means 16 and the second converter 13, however, it could alternatively be connected between the second coupling means 16 and the second terminals 11. The current detector 21 can be used to control the second converter 13 to expose a desired impedance characteristic. In addition to this, the second embodiment of the invention may feature a first voltage detector 22 connected to the DC link 14. The first voltage detector 22 measures the DC voltage. The first converter 12 can transport electricity in accordance with the measured voltage thereby controlling the DC voltage and keeping the DC voltage within sensible bounds. In this way a simple control loop can be set up that will transport any surplus electric power from the DC link to the utility grid. If, for some reason, the flow of power is reversed during some test, electric power could be transported from the utility grid to the DC link 14 by means of the first converter 12 in order to stabilise the DC voltage as required.

In addition, the test unit 2 of the invention may comprise a second voltage detector 23 for measuring the alternating grid voltage. The measured data can be used by the first converter 12 to control the transport of electricity from the DC link 14 to the utility grid and to thereby control the grid voltage. This may be useful in situations where specific grid requirements are to be met.

Fig. 4 shows a third exemplary embodiment of the invention. The test unit 2 shown in Fig. 4 could be any of the embodiments described in this document. The third exemplary embodiment of the invention comprises a first switch 30 which can be useful for setting the test unit into a by-pass mode where the electric power generator will be directly connected to the utility grid. In addition the test unit of the invention may be provided with switches 31 and 33 on the grid side and switches 32 and 34 on the generator side of the test unit 2. The terminals of the test unit 2 can be grounded by turning on switches 33 and 34 while disconnecting the test unit 2 from the generator and the grid by turning off switches 31 and 32. Grounding the inputs of the disconnected test unit has the advantage of easy and safe access to the test unit e.g. for maintenance. The switches 30 through 34 can also be used to configure the test unit as a compensation device such as a static VAr compensator or ASVC.

The test unit of the invention can be provided with a power line communication device. The power line communication device can be used for remote-controlling the test unit and for performing automated tests. In addition the power line communication device can be used for transmitting test data generated during the tests to a remote operator.

While the invention has been described by referring to preferred embodiments and illustrations thereof, it is to be understood that the invention is not limited to the specific form of the embodiments shown and described herein, and that many changes and modifications may be made thereto within the scope of the appended claims by one of ordinary skill in the art.

## Claims

1. A test unit (2) for testing an electric power generator (1) and having first terminals (10) connectable to a utility grid (3) and second terminals (11) connectable to the electric power generator (1), the test unit (2) further comprising a first converter (12) connected between the first terminals (10) and a DC link (14) and a second converter (13) connected between the DC link (14) and the second terminals (11), wherein the first converter (12) is adapted to convert electricity between an alternating grid voltage present at the first terminals (10) and a DC voltage present at the DC link (14) and wherein the second converter (13) is adapted to convert electricity between the DC voltage present at the DC link (14) and an alternating generator voltage present at the second terminals (11).

2. The test unit (2) of the preceding claim, wherein the second converter (13) is adapted to convert electricity in accordance with a control signal variably setting at least one of a frequency, a phase and a voltage level of the alternating generator voltage.

3. The test unit (2) of the preceding claim, wherein the second converter (13) is adapted to convert electricity in accordance with the control signal individually for each phase in a three-phase alternating generator voltage.

4. The test unit (2) of one of the preceding claims, further comprising first coupling means (15) connected between the first terminals (10) and the first converter (12) and second coupling means (16) connected between the second terminals (11) and the second converter (13).

5. The test unit (2) of the preceding claim, wherein the first coupling means (15) are adapted to conduct current between the alternating grid voltage and a first converter voltage which corresponds to the alternating grid voltage divided by a first voltage ratio and wherein the second coupling means (16) are adapted to conduct current between the alternating generator voltage and a second converter voltage which corresponds to the alternating generator voltage divided by a second voltage ratio.

6. The test unit (2) of the preceding claim, wherein at least one of the first and the second coupling means (15, 16) include a transformer.

7. The test unit (2) of the preceding claim, wherein the transformer is a multi-tap transformer.

8. The test unit (2) of claim 4, wherein at least one of the first and the second coupling means (15, 16) include a line reactor.

9. The test unit (2) of one of the preceding claims, further including a current detector (21) connected between the second terminals (11) and the second converter (13) and adapted to measure a current flowing between the electric power generator (1) and the second converter (13).

10. The test unit (2) of the claims 2 and 9, further comprising a controller adapted to determine reference set-points for the electric power generator (1), to transmit the determined reference set-points to the electric power generator (1) and to set an impedance at the second terminals (11).

11. The test unit (2) of one of the preceding claims, further comprising a first voltage sensor (22) adapted to measure the DC voltage of the DC link (14), wherein the first converter (12) is adapted to transport electricity from the DC link (14) to the first terminals (10) in accordance with the measured DC voltage.

12. The test unit (2) of one of the preceding claims, further comprising a second voltage sensor (23) adapted to measure the alternating grid voltage, wherein the first converter (12) is adapted to transport electricity from the DC link (14) to the first terminals (10) in accordance with the measured alternating grid voltage.

13. The test unit (2) of one of the preceding claims, having a weight and size so as to be transportable.

14. The test unit (2) of the preceding claim, wherein the weight and size are such that the test unit (2) can be transported by a motor truck.

15. The test unit (2) of one of the claims 13 or 14, wherein the weight and size are such that the test unit (2) can be transported in an ISO-container or standard trailer.
